# EUROPEAN PATENT SPECIFICATION

(11) **EP 4 715 871 B1**
(45) Date of publication and mention of the grant of the patent: **26.08.2026**
(21) Application number: 25204019.1
(22) Date of filing: 23.09.2025
(51) Int. Cl.: H05K 3/341, H10W 72/00, H10W 72/20, H10W 74/10, H10W 90/00, H05K 1/11, H10W 70/05

(54) **SELF-EXTENDABLE INTERCONNECT STRUCTURES FOR SURFACE MOUNT SEMICONDUCTOR DEVICES**
SELBST-EXPANDIERBARE VERBINDUNGSSTRUKTUREN FÜR OBERFLÄCHENMONTIERTE HALBLEITERANORDNUNGEN
STRUCTURES D'INTERCONNEXION AUTO-EXTENSIBLES POUR DISPOSITIFS SEMI-CONDUCTEURS MONTÉS EN SURFACE

(30) Priority: 24.09.2024 US 202418895332
(43) Date of publication of application: 25.03.2026
(73) Proprietor: Avago Technologies International Sales Pte. Limited, Singapore 768923 (SG)
(72) Inventor: Zhao, Sam Ziqun, Irvine, CA 92618 (US)
(74) Representative: Dilg, Haeusler, Schindelmann Patentanwaltsgesellschaft mbH

(56) References cited:
- JP-A- H1 032 280
- JP-B2- 4 010 311
- US-A1- 2003 234 447
- US-A1- 2014 376 202
- US-A1- 2022 102 256
- US-A1- 2023 309 232

## Description

### BACKGROUND

Surface mounting can be used for high density and high input/output interconnections between semiconductor devices and printed circuit boards (PCBs) or the like. One type of surface mounting is a ball grid array (BGA) technique in which a packaged semiconductor device includes solder balls attached on external terminals of the packaged semiconductor device. The BGA-type package is then placed on to the corresponding terminals/pads on a PCB to make the intended interconnections with the PCB by melting/reflow the solder balls of the BGA package. However, the minimum spacing and the size of the solder balls used in such a technique is limited as may be the overall size of the array due to concerns related to bonded component flatness and warpage. As packaged device sizes increase, standard BGA-type designs may not be sufficient. Similarly, warpage concerns may limit possible boards to which a BGA-type packaged device can be mounted because uniform-sized solder balls may be unable to bridge the various gaps created by warpage amounts in different locations at the bonding surface. The document US 2014/0376202 A1 discloses first electrode pads formed on one semiconductor package surface include a first reinforcing electrode pad having a surface area larger than that of other first electrode pads. The document further discloses second electrode pads formed on a printed wiring board on which the semiconductor package is mounted include at least one second reinforcing electrode pad. The second reinforcing electrode pad opposes the first reinforcing electrode pad, and has a surface area greater than that of the other second electrode pads. The first and second electrode pads are connected by solder connection parts. A cylindrical enclosing member encloses an outer perimeter of a solder connection part connecting the first and second reinforcing electrode pads. The document US 2003/234447 A1 discloses a metallurgical interconnection for electronic devices is described, wherein the interconnection has first and second interconnection metals. The first metal is shaped to enlarge the contact area, thus providing maximum mechanical interconnection strength, and to stop nascent cracks, which propagate in the interconnection. Preferred shapes include castellation and corrugation. The castellation may include metal protrusions, which create wall-like obstacles in the interconnection zones of highest thermomechanical stress, whereby propagating cracks are stopped. The surface of the first metal has an affinity to form metallurgical contacts. The second metal is capable of reflowing. The first metal is preferably copper, and the second metal tin or a tin alloy. The document US 2022/102256 A1 discloses a fan-out semiconductor package, which includes a support wiring structure including a support wiring conductive structure, a plurality of support wiring insulating layers including a first support wiring insulating layer having a recess area and a second support wiring insulating layer on the first support wiring insulating layer and enveloping the support wiring conductive structure. The fan-out semiconductor package includes further a pad layer enveloped by the second support wiring insulating layer and connected to the support wiring conductive structure, and an under-bump metallurgy (UBM) layer enveloped by the first support wiring insulating layer and connected to the pad layer, and a semiconductor chip on the support wiring structure, wherein the UBM layer includes a body portion and a protrusion protruding from the body portion and arranged in the recess area. The document JP 4 310311 B2 discloses an MPU that vibrates a track actuator with a predetermined amplitude while the focus servo loop. The MPU calculates the number of tracks on a disk that the actuator crosses from a track error signal obtained by the vibration and calculates the acceleration performance constant of the track actuator from the ratio between the calculated number of crossed tracks and a reference number of crossed tracks. The document US 2023/309232 A1 discloses a system which includes a reinforcement structure configured to seat in an air gap between one or more solder balls of a ball grid array of a surface mount packaging component. The reinforcement structure is configured and reduce bending of the circuit board during acceleration of the circuit board. The document JP H10 32280 discloses an etching hole which is square, circular, or crossed is provided near the center of the surface of an SMD-type land metal. The etching hole is formed through the land metal so as to reach to the surface of a BT board or is formed as deep as half the thickness of the land metal, and then the etching hole is successively plated with a nickel layer and a gold layer. The surface of a solder ball fused later to come into contact with the land metal is enlarged in area by the etching hole. Furthermore, the etching hole serves also as a locking hole which prevents the solder ball from separating from the land metal after the solder ball is welded to the land metal.

### SUMMARY

In an embodiment, a semiconductor device includes a wiring substrate. A chip, such as a microchip, an integrated circuit device, a semiconductor die, or the like is on a first surface of the wiring substrate. A plurality of protruding portions are on a second surface of the wiring substrate. Each protruding portion includes a solder reservoir space therein that can contain solder so as to permit solder from the reservoir space to flow outward in a solder reflow process for bonding the semiconductor device to a circuit board or the like, wherein a solder level in a solder reservoir space of a first protruding structure in the plurality of protruding structures is different from a solder level in a solder reservoir space of a second protruding structure in the plurality of protruding structures.

In an embodiment, the semiconductor device includes the wiring substrate, the chip on a first surface of the wiring substrate, a resin covering the chip and the first surface of the wiring substrate, and each of the protruding portions comprises a mounting post on the second surface of the wiring substrate. Each mounting post extends from the second surface in a first direction substantially orthogonal to the second surface. A solder ball is on an end of each mounting post farthest from the wiring substrate in the first direction. In this context, "substantially" means within in normal, standard, or customary manufacturing tolerances and/or associated measurement of such. For example, within 25% of a nominal value. Each mounting post includes therein a solder reservoir space, and at least one solder reservoir space has solder therein.

In an embodiment, an electronic device includes a circuit board with a plurality of mounting pads at a surface thereof and a semiconductor device soldered to the plurality of mounting pads. The semiconductor device comprises a wiring substrate, a chip on a first surface of the wiring substrate, and a plurality of protruding portions on a second surface of the wiring substrate. Each protruding portion of the semiconductor device includes a solder reservoir space therein.

In an embodiment, a semiconductor device includes a package substrate with a chip, such as a microchip, an integrated circuit device, semiconductor die, or the like on a first surface of the package substrate. The package substrate has a plurality of solder reservoirs therein. The solder reservoirs are connected to solder balls on a second surface of the package substrate for mounting the package substrate to a circuit board or the like. Each solder reservoir has a vent portion connected thereto. The vent portion connects the interior of the solder reservoir to an ambient atmosphere.

### BRIEF DESCRIPTION OF THE DRAWINGS

Fig. 1 is a schematic depiction of bonding issues with a ball grid array device.
Figs. 2A-2E depict aspects of a surface mounting packaged semiconductor device with self-extendable interconnectors according to a first embodiment.
Figs. 3A-3C depict aspects of a self-extendable interconnector according to a first embodiment.
Fig. 4 depicts an example mounting process involving a surface mounting packaged semiconductor device with self-extendable interconnectors according to a first embodiment.
Fig. 5 depicts aspects of a method of manufacturing a surface mounting packaged semiconductor device with self-extendable interconnectors according to a first embodiment.
Figs. 6A-6C depict aspects of a self-extendable interconnector according to a second embodiment.
Fig. 7 depicts aspects of a surface mounting packaged semiconductor device with self-extendable interconnectors according to a second embodiment.
Figs. 8A and 8B depict aspects of a self-extendable interconnector according to a third embodiment.
Fig. 9 depicts aspects of a surface mounting packaged semiconductor device with self-extendable interconnectors according to a third embodiment.
Fig. 10 depicts aspects of a surface mounting packaged semiconductor device with self-extendable interconnectors according to a fourth embodiment.

### DETAILED DESCRIPTION

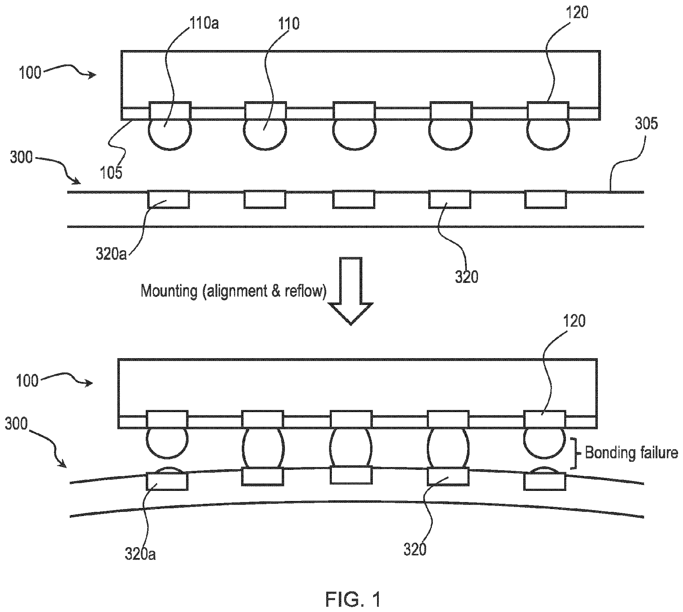

Fig. 1 schematically depicts certain issues related to bonding of a packaged semiconductor device to a circuit board or the like. In particular, Fig. 1 shows a packaged semiconductor device 100 mounted on to a circuit board 300. Circuit board 300 is depicted as bent or warped downwardly across the region onto which semiconductor device 100 is intended to be mounted. The depicted bending or warping is schematic and/or exaggerated for purposes of description. The warping/bending may also, or instead, be upward, upward and downward within the same board region, non-continuous across the mounting region, uneven, wavy, or the like. The warping of circuit board 300 may not be present or noticeable initially, but rather may arise during the mounting processing or processes associated with the mounting process. The warping may vary during different stages of the manufacturing process. The semiconductor device 100 may itself be non-flat, bent, warped, or the like but for simplicity in illustration only the warping of circuit board 300 is specifically depicted in this example.

As seen in Fig. 1, initially, semiconductor device 100 has solder balls 110 arrayed on pads 120 located on a mounting side 105. Circuit board 300 likewise has pads 320 located on a mounting surface 305. The pads 320 may be referred to as mounting pads and/or board terminals. In general, pads 320 are provided to permit electrical connections to be made (via soldering) between the semiconductor device 100 and the circuit board 300. Pads 320 may be provided for electrical signals, electrical power, grounding, or the like. In some examples, pads 320 may be provided for structural (non-electrical) purposes and may be referred to in some such cases as dummy pads or dummy terminals. The pads 320 correspond in planar position to the pads 120 (and thus the solder balls 110). Pads 320 may also have solder thereon initially before mounting, but such is not specifically depicted in this example. The mounting side 105 of the semiconductor device 100 is brought into a facing arrangement with the mounting surface 305 of the circuit board 300. The relative positioning of the semiconductor device 100 and the circuit board 300 is controlled such that the individual solder balls 110 will be positioned above a corresponding one of the pads 320. Once aligned, the semiconductor device 100 and the circuit board 300 are then brought into contact or near proximity. A thermal reflow (a heating process) is then used to permit the solder balls 110 to bond to the pads 320. The connections made via the solder balls 110 (or the solder therefrom) between the semiconductor device 100 and the circuit board 300 may be referred to as interconnections or interconnectors. This bonding and reflow method can be used to form an electronic device, electronic device component, or the like comprising the circuit board 300 and the semiconductor device 100 mounted thereon.

In the thermal reflow process, differences in composition and thermal expansion coefficients of components may induce warping or relative warping amounts resulting, as depicted in Fig. 1, in bonding failures at certain pads 320. Fig. 1 shows bond failures at the outermost pads 320 (320a), but failures may be at any location and need not be symmetric across the mounting region. Bonding failures at pads 320a may be considered to result from a lack of solder at the intended bonding location. That is, the size of the solder ball 110a was insufficient to permit the spanning of the gap induced by the warping of circuit board 300.

While increased sizes solder balls 100 might be adopted to compensate for potential warping, this would require larger pad 120 spacing intervals and/or increase the likelihood electrical shorts developing between adjacent solder balls 110 at positions where the gap between circuit board 300 and semiconductor device 100 is less than the maximum. Increasing pad 120 spacing (and thus pad 320 spacing) would reduce solder balls count available for the device. Increasing only certain specific solder ball 110 sizes would, in addition to increasing process/design complexity, face issues with determining beforehand the specific locations requiring the extra solder, which need not be consistent circuit board 300 to circuit board 300 nor semiconductor device 100 to semiconductor device 100.

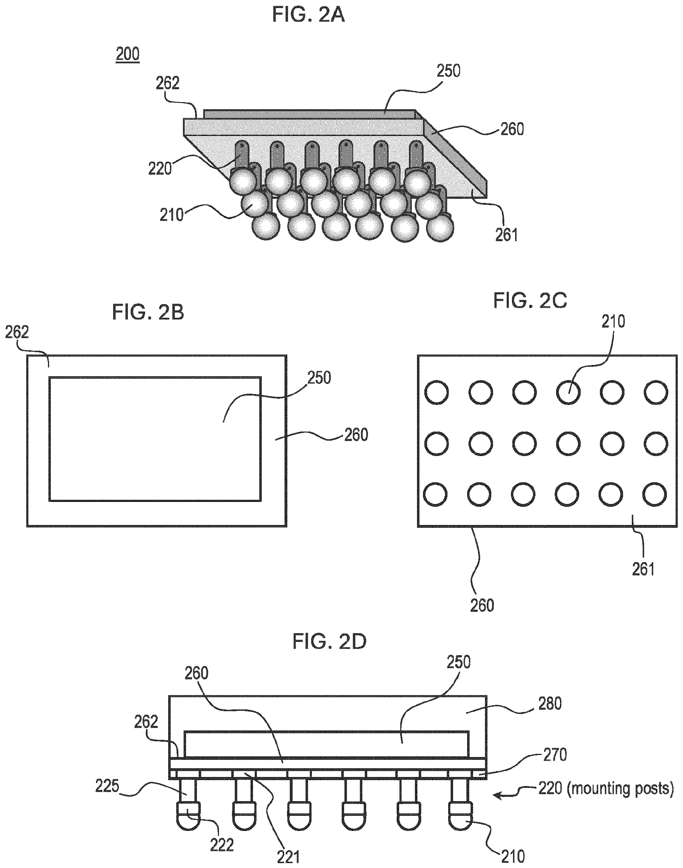

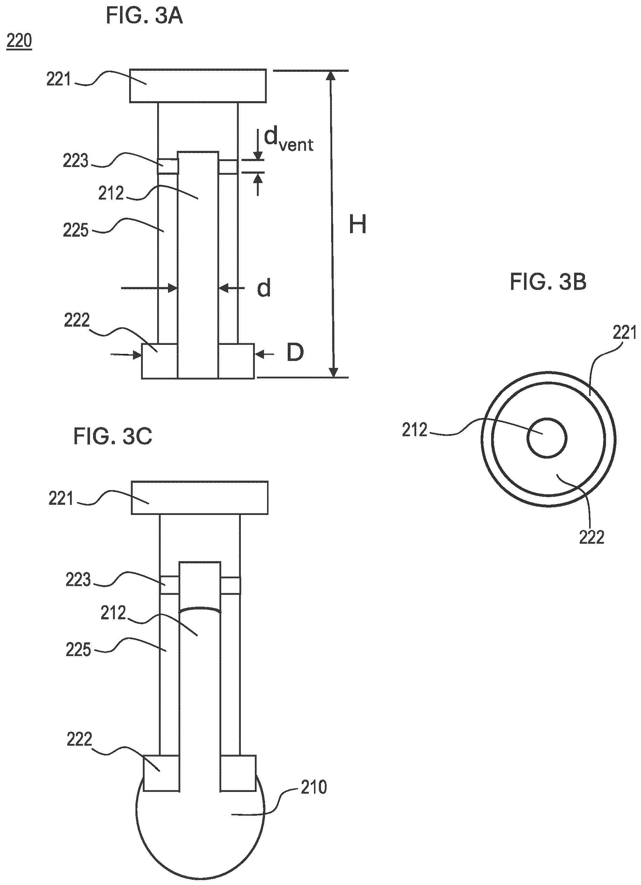

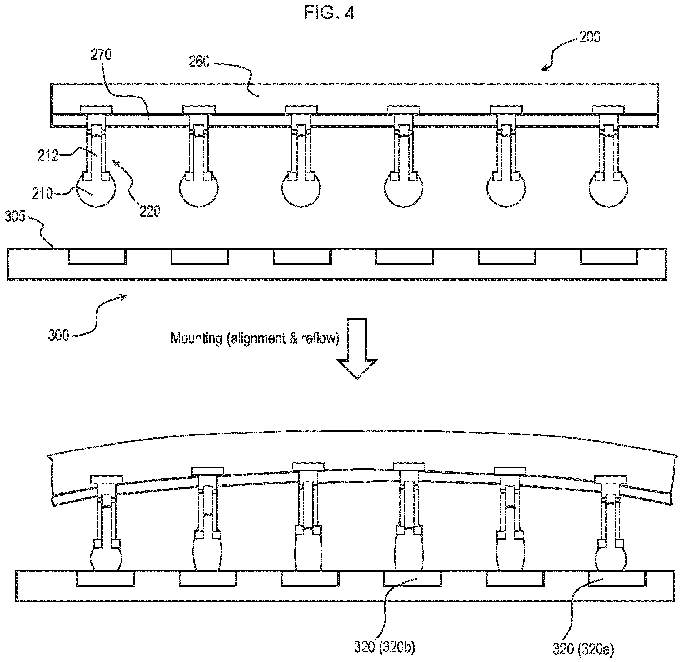

Fig. 2A depicts a packaged semiconductor device 200 according to a first embodiment in a perspective view. Semiconductor device 200 differs from semiconductor device 100 by inclusion of mounting posts 220 instead of pads 120 of semiconductor device 100. The mounting posts 220 are an example of protruding structures and may be referred to as such. A solder ball 210 is present at the lower end of each mounting post 220. The semiconductor device 200 can be mounted to a circuit board 300 in a manner similar to that depicted in Fig. 1. However, each mounting post 220 includes therein or therewith a reservoir 212 (see Fig. 3) from which additional solder may be stored and flow from during a solder reflow process so as to supplement, as needed, the solder provided by the connected solder ball 210. The reservoir 212 is one example of a solder reservoir space. For example, a semiconductor device 200 can be mounted to a circuit board 300 (as depicted in Fig. 4) with solder from the reservoirs 212 of different mounting posts 220 flowing outward from the reservoir space to allow for solder connections of different lengths (total solder amounts) to compensate for warpage, unevenness, or the like in circuit board 300 and/or semiconductor device 200. The mounting posts 220 may be referred to as self-extendable interconnect structures for surface mount semiconductor devices in view of the ability to provide additional solder from the reservoir 212 for the making of interconnections at certain positions along the lower surface 261 (mounting side) of semiconductor device 200. In this description, terms such as "lower" and "upper" are used merely for convenience in description of relational aspects of particularly depicted examples in the drawings. No fixed orientation relative to a standard gravitational orientation or otherwise is intended or implied, and in other examples, arrangements, or orientations, lower surface 261 may be above upper surface 262.

In general, packaged semiconductor device 200 includes a chip 250 mounted on a wiring substrate 260. The wiring substrate 260 may be referred to as a package substrate in some examples. The chip 250 and upper surface 262 of the wiring substrate 260 can be optionally covered with resin 280 in whole or in part. After mounting of chip 250, chip 250 may be said to be "on wiring substrate 260." In this context, "on" encompasses being either directly or indirectly on the upper surface 262 of wiring substrate. That is, the chip 250 can be attached to wiring substrate 260 in various manners such as adhesive, conductive paste, soldering, etc. Similarly, an interposer element or other components may be provided between the chip 250 and the wiring substrate 260. Electrical connections between chip 250 and wiring substrate 260 can be made in various manners such as bonding wires, flip chip die bonding, direct mounting, soldering, pin connectors, leadframes, and the like.

Wiring substrate 260 may include multiple wiring levels to make the electrical connections between mounting posts 220 and terminals, electrodes, pads, or the like of chip 250. Wiring substrate 260 may be a printed circuit board in some examples. Wiring substrate 260 may be, or comprise, a ceramic substrate, an organic substrate, a chip carrier, a metal leadframe, or the like.

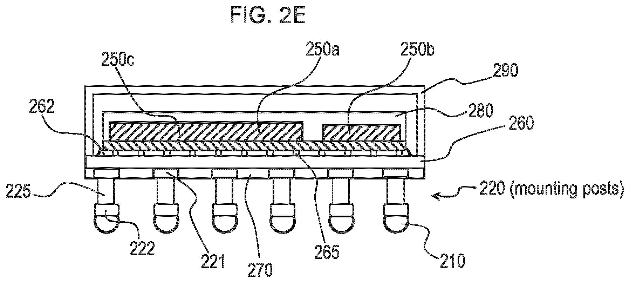

While Fig. 2A depicts chip 250 as single unitary component, chip 250 may be, or comprise, multiple chips, dies, or elements that may all be mounted to the same wiring substrate 260, either side-by-side with one another in a planar direction, or stacked one upon the other, or combination of these arrangement in 2.5D, 3D, or 3.5D structures. That is, chip 250 may be or comprise a stack or arrangement of individual chips, dies, elements, or the like. Such individual chips, dies, elements, or the like may be the same or different as one another. Fig. 2E depicts a specific example in which a semiconductor device 200 is provided with multiple chips 250 (e.g., a chip 250a and a chip 250b) arranged side-by side with one another. Fig. 2E also depicts an example of a semiconductor device 200 that is provided with stacked chips 250 (e.g., a chip 250a and a chip 250c).

A chip 250 may comprise, or be, an integrated circuit device, an IC chip, a processor, a transceiver, a network adapter chip, a digital application specific integrated circuit (ASIC), a memory chip, a switch, an optoelectronic component, a micro-electromechanical machine, a microcontroller, a digital signal processor, a digital-to-analog converter, an analog-to-digital converter, a system-on-chip, an application specific integrated circuit, an amplifier, a preamplifier, or the like.

A packaged semiconductor device 200 incorporating a chip 250 may likewise be said to be, or comprise, an integrated circuit device, an IC chip, a processor, a transceiver, a network adapter chip, a digital ASIC, a memory chip, a switch, an optoelectronic component, a micro-electromechanical machine, a microcontroller, a digital signal processor, a digital-to-analog converter, an analog-to-digital converter, a system-on-chip, an application specific integrated circuit, an amplifier, a preamplifier, or the like according to the included chip 250 type(s).

The wiring substrate 260 includes a solder mask 270 (also referred to as a resist mask) on a lower surface 261. Solder mask 270 (see Fig. 2D) can be a layer of insulating material that is commonly formed on printed circuit board surfaces to help control the solder positioning and protect/seal the board/substrate interior. The solder mask 270 may be a resin or polymeric material that may be initially applied as a liquid, a film, or the like, then subsequently hardened or cured. Similar material may be found on upper surface 262 in some examples.

Resin 280 (see Fig. 2D) may be optional in some examples. However, when present, resin 280 serves to encapsulate and protect chip 250 and the upper surface 262 of wiring substrate 260. Resin 280 may encapsulate a chip 250 entirely. Resin 280 may have a top surface that may be flush with the top surface of 250 to expose the top surfaces of dies (chips 250a and 250b) in Fig. 2E for heat dissipation. Resin 280 side walls may be flush (aligned) with the side walls of chip 250c in Fig. 2E. Resin 280 may help prevent physical (e.g., abrasions) or environmental-induced damage (e.g., corrosion). Resin 280 may be a potting resin, a thermosetting plastic, a moldable thermoplastic, or the like. Other sealant or protective coatings may be adopted other than, or in addition to, resin 280. In some examples, resin 280, or the equivalent, may be applied after the bonding of semiconductor device 200 to circuit board 300.

Mounting posts 220 are electrically conductive structures. In the first embodiment, mounting posts 220 comprise hollow conductive metal tubes. These metal tubes include a tube portion 225 (see Fig. 2D) and the interior region of the tube portion 225 provides most of the space for reservoir 212 (see Fig. 3A). Some fraction of the reservoir 212 total volume is provided by the through-hole region in lower pad portion 222(see Fig. 2D and Fig. 3A). In general, any solid state electrical conductor may be used for forming mounting posts 220. In a particular example, mounting posts 220 may be copper and formed by a copper plating process on the wiring substrate 260 occurring before the mounting/bonding of chip 250 to the wiring substrate 260.

Fig. 2B depicts a top down view (e.g., the view looking downward towards upper surface 262) of a packaged semiconductor device 200. In this example, depiction of resin 280 is omitted. Chip 250 has a planar (projected) area that is less than the planar (projected) area of wiring substrate 260. This is not necessarily required and the relative sizing of chip 250 and wiring substrate 260 may be different from that depicted. The sizes may be equal or inverse from that shown. Likewise, while depicted as centered upon wiring substrate 260, the planar center of chip 250 may be offset from the planar center of wiring substrate 260. Chip 250 may comprise multiple portions, pieces, or the like, some or all of which may be spaced from each other on the upper surface 262. Other electronic components besides a chip 250 may be present on the wiring substrate 260. Upper surface 262 need not be fully planar (flat) and may also include structural features such as rigids, grooves, steps, channels, terminals, mounting pads, frame portions, wiring bonding pads, wiring traces, sockets, connectors, or the like.

Fig. 2C depicts a bottom up view (e.g., the view looking upward towards lower surface 261) of a packaged semiconductor device 200. In this example, the solder balls 261 have a diameter larger than the largest outer diameter of the mounting posts 220. Thus, Fig. 2C shows only solder balls 261 on the lower surface 261 side of semiconductor device 200. In some examples, solder balls 261 may have a diameter that is less than the largest outer diameter of the mounting posts 220. Specific depiction of solder mask 270 is omitted in Fig. 2C, though such a component may be present in some examples.

In Fig. 2C, the arrangement of solder balls 261 is a regular rectangular array, though such is not necessarily required. The view depicted in Fig. 2C could, in general, be indistinguishable from a bottom-up view of the semiconductor device 100 depicted in Fig. 1. Such similarity can serve to promote compatibility of semiconductor devices 200 with existing circuit boards 300 and the like.

Fig. 2D depicts a cross-sectional view of a packaged semiconductor device 200. Resin 280 is shown covering chip 250 and the upper surface 262 of the wiring substrate 260, but this is only an example. In other examples, resin 280 may cover or encapsulate only the chip(s) 250, or resin 280 may only partially cover the chip(s) 250 and/or the upper surface 262. In still other examples, resin 280 need not contact the upper surface 262 at all or may be entirely absent from the semiconductor device 200. Solder mask 270 is shown covering the lower surface 261 of wiring substrate 260. Additional aspects of the mounting posts 220 are evident in Fig. 2D. Each mounting post 220 is shown to include a tube portion 225, a lower pad portion 222 (on which a solder ball 210 is disposed), and an upper pad portion 221 at the lower surface 261. Additional aspects of a mounting post 220 will be discussed in conjunction with Figs. 3A and 3B.

Fig. 2E depicts a specific example of the first embodiment. In Fig. 2E, packaged semiconductor device 200 comprises a first chip 250a and a second chip 250b arranged side-by-side on an upper surface of an interposer chip 250c. The first chip 250a, second chip 250b, and interposer chip 250c (collectively, chips 250) are covered by resin 280. Interposer chip 250c is mounted on the wiring substrate 260 via interconnections 265. A heat dissipation component 290 covers the chips 250 and the upper surface 262 of the wiring substrate 260. The heat dissipation component 290 may comprise metal in whole or in part or may be other materials. The heat dissipation component 290 may contact one or more chips 250 or be otherwise thermally connected to the one or more chips 250 to promote heat dissipation. In some examples, heat dissipation component 290 may be a shielding component that is electrically grounded, or designed to be electrically grounded, via a ground terminal, ground plane, or wiring trace of the wiring substrate 260 or otherwise. In this example, the first chip 250a is a digital ASIC and second chip 250b is a memory chip. The interposer chip 250c is a silicon wafer portion with one or more wiring levels therein and connection pads on the upper and lower surfaces. The interposer chip 250c in this example may lack active elements such as transistors or the like.

Fig. 3A shows structural details of a mounting post 220. The depicted mounting post 220 is one example of a self-extendable interconnector or interconnect structure. As shown, mounting post 220 includes an upper pad portion 221, a tube portion 225, a vent portion 223, and a lower pad portion 222. The depicted dimensions of these portions and dimensional relationships between the various portions are merely exemplary and not limitations upon the present disclosure. Fig. 3B shows an end-on view depicting each of the upper pad portion 221, the reservoir portion 212, and the lower pad portion 222 as circular components in this example. While circular shaped components may be preferable in many examples, such is not required and the various depicted components may instead be triangular, square, rectangular, polygonal, semicircular, or otherwise.

Fig. 3A shows the end-to-end distance (H) of the mounting post 220 to be the sum of the heights of the upper pad portion 221, the tube portion 225, and the lower pad portion 222. The various dimensions, sizes, and shapes of the mounting posts 220 and its sub-components can be set in view of requirements of connector density, expected warpage, process tolerances, overall device size, required electrical performance characteristics, and the like.

The upper pad portion 221 is connected to (or embedded within) the lower surface 261 of wiring substrate 260. Solder mask 270 may surround the upper pad portion 221 in whole or in part. The lower pad portion 222 has an outer diameter (D) that can be the same or different as the outer diameter of the upper pad portion 221. As depicted in Fig. 3A and Fig. 3B, the outer diameter (D) of the lower pad portion 222 is less than outer diameter of the upper pad portion 221. The outer diameter of the tube portion 225 is less than the outer diameters of the lower pad portion 222 and the upper pad portion 221. Such a disposition of outer diameters is not necessarily required and the outer diameter can be the same for each portion (e.g., mounting post 220 has a constant outer diameter) or may vary portion to portion as depicted or otherwise. In some examples, the lower pad portion 222 may be indistinguishable from the tube portion 225.

The inner diameter (d) of the hollow portion of tube portion 225 and the through-hole diameter in lower pad portion 222 are equal and constant in the depicted example. This is not necessarily required and these diameters may be different and/or may be non-constant within a portion. For example, the inner sidewall of tube portion 225 may be angled, as may be the inner sidewall of the through-hole in the lower pad portion 222. Tube portion 225 may have tapered or tapering inner or outer sidewalls. Such taper may be in either an upward or downward direction. Tube portion 225 may have inner chambers, divisions, or internal supporting structure such as crosspieces spanning the hollow portion that may be present without fully blocking solder flow. In Fig. 3A, the reservoir 212 does not extend the entire length of the tube portion 225 to reach the upper pad portion 221. The length (height direction) of the reservoir 212 may reach the upper pad portion 221 in some examples.

In general, the inner diameter (d) of tube portion 225 can be set by design in conjunction with the total length of the hollow portion according to expected, calculated, or desired solder capacity requirements for reservoir portion 212. A vent portion 223 is provided in the tube portion 225 nearer the upper pad portion 221 than the lower pad portion 222. Vent portion 223 is provided in part to allow solder to flow from the lower end of reservoir portion 212 during solder reflow processing. Without vent portion 223, the upper end of reservoir portion 212 may be sealed from atmospheric/ambient pressure and solder in reservoir portion 212 would experience vacuum-type resistances to outward flow as well as difficulties with the initial filling of the reservoir portion 212 with solder.

As depicted in this example, two vent portions 223 are provided as relatively small holes opposite to one another across the tube portion 225 diameter. Fig. 3A shows the vent portions 223 having a diameter (dᵥₑₙₜ) that is small in size relative to the inner diameter (d) of tube portion 225.

The number, position, and sizing of the vent portions 223 may be decided according to solder reflow or reservoir filling performance characteristics. There is no particular limit on the number, sizes, arrangements, or positioning of vent portions 223. A single vent portion 223 may be provided or a plurality of vent portions 223 may be provided. When multiple vent portions 223 are provided, they may each be the same size and shape or may be different sizes and shapes. Arrangements and dispositions of vent portions 223 may be, but need not be, symmetric about an central axis of the reservoir portion 212. Vent portions 223 may be provided at different positions (heights) along the length reservoir portion 212.

Fig. 3C shows a mounting post 220 in a solder-filled state. In this state, a portion of the hollow tube portion 225 is filled with solder and a solder ball 210 is formed on the lower pad portion 222. The sizing of solder ball 210 may be controlled in part by control of surface properties of the outer surfaces of the lower pad portion 222. For example, making the outer side surface of lower pad portion 222 more or less wettable by the solder can control the position of upper edge of the solder ball 210. Fig. 3C shows the upper edge of the solder ball 210 being approximately halfway up the outer side surface of the lower pad portion 222. In other examples, the upper edge of the solder ball 210 may be at the lower or upper edge of the outer side surface of the lower pad portion 222 or stopped at position on the downward facing surface of the lower pad portion 222.

Though Fig. 3C depicts solder within tube portion 225 having a convex meniscus shape, this is not necessarily required. The meniscus may instead be concave or flat. In general, meniscus shape may depend on the surface properties of the inner walls of tube portion 225, the wettability characteristics of the solder, and/or environmental characteristics during solder filling processes or the like. By modifying the inner walls of the tube portion 225 using surface treatment methods such as applying a material coating, performing a surface oxidation, or other treatments, different sections of the inner walls of tube portion 225 may have a different affinity with solder material in a molten state and the meniscus surface shape may change between convex, concave, and flat due to changes in solder wettability.

The surface properties of portions of the mounting post 220, such as the lower pad portion 222 (or any portion the mounting post 220) may be adjusted by coating or plating of materials thereon to alter solder wettability. For example, a thin layer of tin, solder alloy, silver, gold, or the like can improve solder wetting and promote solder spreading to increase the size of solder ball 210. The diameter of solder balls 210 can be greater than the diameter of the lower pad portion 222 in some examples, such as depicted in Fig. 3C, but such is not necessarily required.

Solder ball 210 size on the lower end of metal post 220 and reservoir 212 filling is controlled by a capillary force balance equation: $πdσcosΘ + πDσ = {ρghπd}^{2} / 4 + ρ {gV}_{ball}$ where d is the inner diameter of tube portion 225, σ is surface tension of the molten solder, Θ is the contact angle between molten solder and the outer surface of the lower pad portion 22, D is the outer diameter of the lower pad portion 222, ρ is the density of the solder, g is force of gravity, h is the height (length) of the solder inside the reservoir 212, V_{ball} is the total volume of solder ball 210, and π is the standard mathematical constant.

Fig. 4 schematically depicts an example mounting processing in which a packaged semiconductor device 200 is mounted to a circuit board 300. The top portion of Fig. 4 shows a pre-mounted state in which solder balls 210 are present at the lower end of each mounting post 220 and each reservoir 212 is filled with or contains solder. The filling level of solder (solder level) within each reservoir 212 is approximately the same for each mounting post 220 initially. In this example, no solder is depicted as present on the pads 320 before the mounting, but, in other examples, solder, solder balls, solder bumps, solder layers, or the like may be already present on the pads 320 before the mounting of packaged semiconductor device 200.

The bottom portion of Fig. 4 shows a post-mounting state (post-reflow processing) in which solder balls 210 have been respectively joined to the pads 320 on the mounting surface 305 of the circuit board 300. The solder interconnections at the interior pads 320b are different in length/size than the solder interconnects at the exterior (outermost) pads 320a. In this example, the distance (gap) between packaged semiconductor device 200 and circuit board 300 is greatest in the interior region and thus solder interconnections at pads 320b are longer than at pads 320a. Correspondingly, the amount of solder remaining within the reservoirs 212 of different mounting posts 220 after reflow processing are also different. That is, the solder level within the reservoirs 212 of different mounting posts 220 are different depending on location within the packaged semiconductor device 200. If the gap distance was the reverse from that depicted in Fig. 4 (see, e.g., Fig. 1), then the size relationship between the different solder interconnections would be the reverse from that depicted in Fig. 4. In this depiction in Fig. 4, warpage is shown as being present primarily in the packaged semiconductor device 200 rather than the circuit board 300, but this is only an example and warping, bending, unevenness or the like may be present in either one (or both) of packaged semiconductor device 200 and circuit board 300.

Once the packaged semiconductor device 200 and the circuit board 300 are brought together, a reflow process at elevated temperature is performed so the initially solid solder will melt to permit the joining (soldering) of the packaged semiconductor device 200 to the circuit board 300. In this reflow process, solder may flow from the reservoirs 212 as available and join with the solder of the solder ball 210 to make interconnections. Thus, after the reflow process, in the mounted state, the reservoirs 212 of certain mounting posts 220 may remain filled or the reservoirs 212 may be empty or partially emptied depending on the local differences in distances between the circuit board 300 and the lower end of the mounting posts 220 or other aspects during the reflow process. Outward flow of solder from the reservoir 212 may be limited by a capillary force balance related to the size of the solder ball 210 during the reflow process.

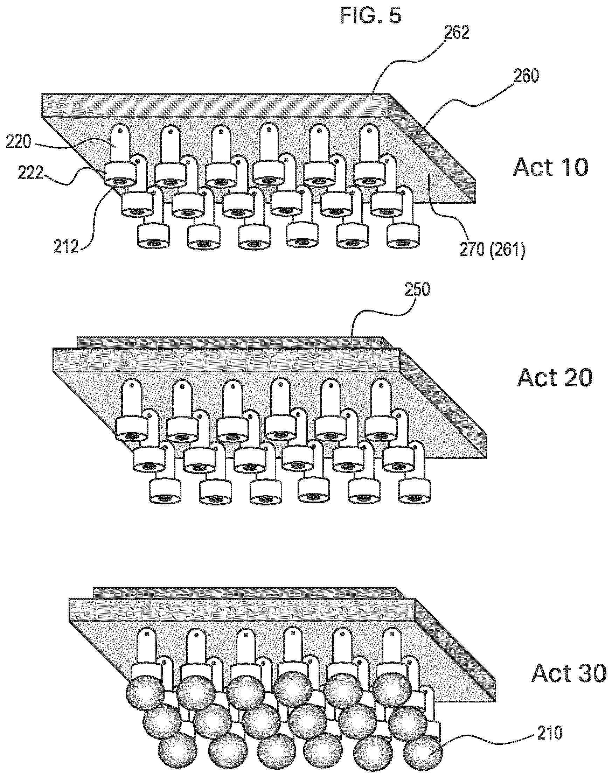

Fig. 5 depicts aspects of a method for manufacturing a packaged semiconductor device 200. In Act 10, a wiring substrate 260 is prepared. The various internal wiring connections and the terminals, pads, electrodes, and the like on upper surface 262 are prepared. The mounting posts 220 are formed on lower surface 261. For example, the mounting posts 220 are copper and formed in a copper plating process in which solder mask 270 or other insulating material is already present on the non-metal portions of lower surface 261. In other examples, solder mask 270 may be applied at another point in the processing or omitted. The formation of mounting posts 220 may include various photoresist patterning steps, metal additive steps, and/or metal subtractive steps and may be performed in stages. Mounting posts 220 may be integrally formed with the wiring substrate 260 or attached thereto in some manner, such adhesive, brazing, bonding, or the like.

In Act 20, chip 250 is mounted on upper surface 262 of the wiring substrate 260. The method of attachment is not particularly limited. For example, chip 250 may be mounted by flip chip die bond, adhesive, conductive paste, soldering, or the like. In some examples, Act 20 may occur before Act 10, and the ordering of these steps may be reversed. As part of Act 20, resin 280 may be applied, but this is not specifically depicted in Fig. 5 (but see Fig. 2D).

In Act 30, the solder is filled into the reservoirs 212 of the mounting posts 220 and the solder balls 210 are formed on the lower pad portions 222 of the mounting posts 220. The reservoir filling and the solder ball placement process may be a single process or may occur in stages.

After Act 30, the packaged semiconductor device 200 can be considered complete and ready for mounting on a circuit board or the like. The packaged semiconductor device 200 may be considered a final product or may be considered an intermediate product requiring additional processing before completion. In any event, the mounting process depicted in Fig. 4 may now be performed to prepare a circuit board product, electronic device, or the like.

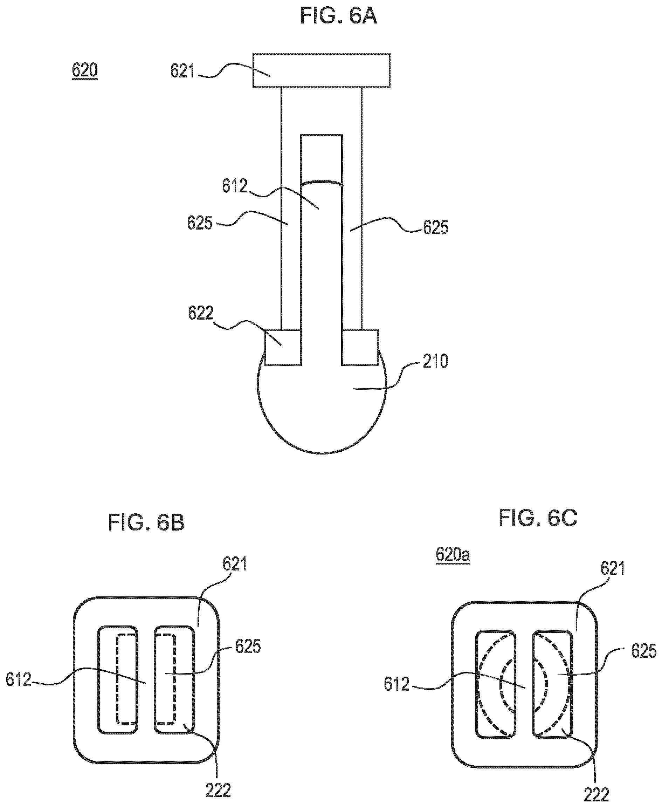

The mounting posts 220 depicted in Figs. 3A and 3B are one example. In other examples, a packaged semiconductor device may incorporate one or more variations providing similar effects as mounting posts 220 though having differences in design or arrangement components. Fig. 6A depicts a twin plate mounting post 620. With mounting post 620, two plate portions 625 provide the space for a reservoir 612 into which solder may fill by capillary action in a manner similar to reservoir 212. The reservoir 612 is one example of a solder reservoir space. A dedicated vent portion is not required for mounting post 620 since the reservoir 612 is not fully enclosed. The vent portion in this context may be considered to correspond openings/spaces between plate portions 625. The upper pad portion 621 connects the two plate portions 625 at the upper end of the mounting post 620.

The plate portions 625 can be sized to collectively provide surface area on a lower end for a solder ball 210 or lower pad portion 622 may be formed thereon as depicted in Fig. 6A. The lower pad portion 622 in some examples may span between the two plate portions 625

The plate portions 625 need not be simple rectangles in cross-section as depicted in the end on view of Fig. 6B, but may have more complex cross-sectional shapes such as semicircular, crescent, or the like. The plates 625 need not be flat, fully planar, nor constant thickness. For example, each plate 625 may be, or comprise, a curved shape such as depicted in Fig. 6C for a mounting post 620a. Plates 625 or portions thereof may be angled, tilted, wedge-shaped, or the like. Furthermore, the cross-sections of plate portions 625 need not be constant along the length of the plate portions 625, nor must both plate portions 625 have the same cross-sectional shape as each other.

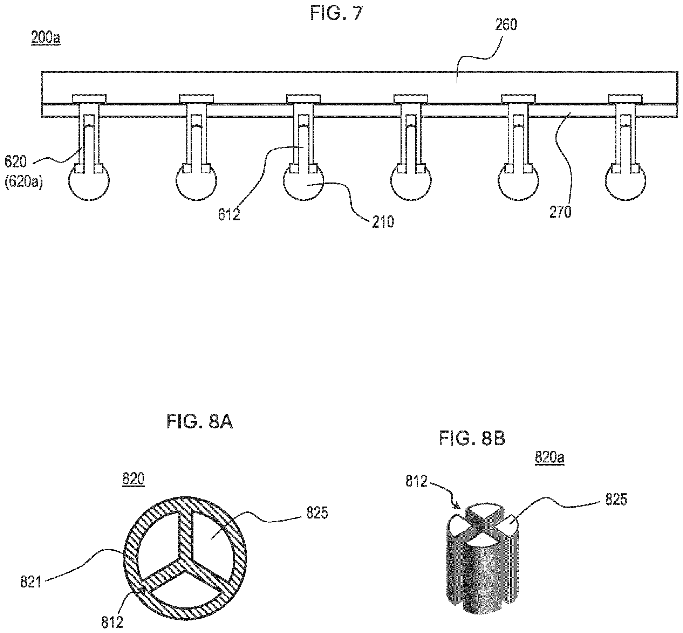

Fig. 7 depicts a packaged semiconductor device 200a incorporating mounting posts 620. In general, packaged semiconductor device 200a is substantially similar to packaged semiconductor device 200 excepting mounting posts 620 are used instead of mounting posts 220. Packaged semiconductor device 200a may be used in a manner similar to that depicted in Fig. 4 for semiconductor device 200. Similarly, packaged semiconductor device 200a may be manufactured by a method corresponding to Fig. 5.

In another example, a packaged semiconductor device may incorporate mounting posts 820. Fig. 8A depicts a three-prong mounting post 820 in an end-on view. At this point, solder is absent from the depicted structure and only the mounting post 820 structure is shown. Each mounting post 820 extends lengthwise in a manner similar to that depicted in Fig. 2D (and see also Fig. 8B). Within each mounting post 820, there are three prong portions 825 arranged that together provide the space for a reservoir 812 into which solder may fill by capillary action in a manner similar to reservoir 212 (or reservoir 612). The reservoir 812 is one example of a solder reservoir space. A dedicated vent portion is not required for mounting post 820 since the reservoir 812 is not fully enclosed. The vent portion in this context may be considered to correspond to openings/spaces between prong portions 825. As depicted in Fig. 8A, an upper pad portion 821 connects the three prong portions 825 at the upper end of the mounting post 820. That is, each of the prong portions 825 extends outwardly from a shared upper pad portion 821.

The prong portions 825 can be sized to collectively provide surface area on a lower end for a solder ball 210. Similar to that depicted in Fig. 3C, the solder ball 210 may extend upward along outer sidewall of the prong portions 825 or may limited to the lower facing surfaces at the ends of the prong portions. The inner facing sidewalls of the prong portions 825 and the gaps therebetween form the space for reservoir 812.

In other examples, the prong portions 825 need not be uniformly sized for the full length of the prong portions 825 and a lower pad portion (a mounting end portion) or the like may be formed on some or all of the prong portions 825. In some examples, the lower pad portion may span in span between or connect adjacent prong portions within the three prong portions 825. Likewise, structure for supporting prong portions 825 may be present at one or more points along the length of the prong portions 825.

The prong portions 825 in Fig. 8A are depicted as sub-portions of an overall circular shape, however, this is just one example. The prong portions 825 may have other shapes and arrangements. For example, each prong portion 825 may have a cross-section that is square, rectangular, triangular, oval shaped, wedge shaped, or combinations thereof. Together the prong portions 825 need not be positioned to form an overall circular shape, but may be arranged as points on a square, rectangle, or otherwise. Prongs portions 825 need not all be the same shape or size as each other within the same mounting post 820. Various combinations of sizes, shapes, positions, and the like for the prong portions 825 may be adopted.

Fig. 8B depicts a mounting post 820a. In Fig. 8B, solder is absent from the depicted structure and only the mounting post 820a structure is shown. Mounting post 820a has four prong portions 825 as compared to three prong portions 825 for the mounting post 820 (depicted in Fig. 8A). As noted above, the shapes, numbers, arrangements, and relative positions of the prong portions 825 can be varied. Mounting post 820a lacks a separate or distinct upper pad portion 821. That is, as depicted in Fig. 8B, prong portions 825 may separately meet the wiring substrate 260 rather than an upper pad portion 821. Mounting post 820a is otherwise similar to mounting post 820.

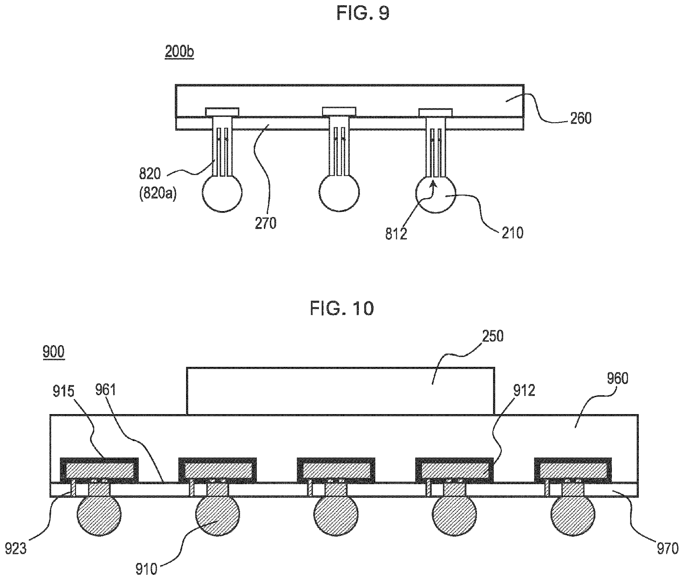

Fig. 9 depicts a packaged semiconductor device 200b incorporating mounting posts 820. In general, packaged semiconductor device 200b is substantially similar to packaged semiconductor device 200 excepting mounting posts 820 are used instead of mounting posts 220. packaged semiconductor device 200b may be used in a manner similar to that depicted in Fig. 4 for semiconductor device 200. Similarly, packaged semiconductor device 200b may be manufactured by a method corresponding to Fig. 5.

Fig. 10 depicts aspects of a semiconductor device 900 according to a fourth embodiment. Like the previous embodiments, the fourth embodiment includes a solder reservoir from which solder may flow during reflow processing, however, in this fourth embodiment, the solder reservoir is present within the wiring substrate (package substrate) rather than within mounting posts (protruding structures). Provision of a solder reservoir in the wiring substrate provides benefits similar to those discussed above in conjunction with Fig. 4.

In this fourth embodiment, package substrate 960 of semiconductor device 900 includes, in a portion thereof, reservoirs 912. In general, package substrate 960 corresponds in its position and purpose within semiconductor device 900 to wiring substrate 260 within semiconductor device 200 discussed above. A chip 250 or the like may be mounted upon the upper surface of package substrate 960. Package substrate 960 may ultimately be mounted via solder balls 910 onto a circuit board 300 or the like in a process similar to that shown in Fig. 4.

Within the package substrate 960 are the reservoirs 912, which are spaces/voids inside the package substrate 960. As depicted in cross-section in Fig. 10, each reservoir 912 has a rectangular structure and is at or near the lower surface 961 of the package substrate 960. The reservoirs 912 are depicted as filled with solder in Fig. 10. In general, the shape of the reservoir 912 is not limited to rectangular and the sidewalls may be sloped, curved, or irregular. The sidewalls 915 of reservoir 912 may be a conductive metal or covered with a conductive metal or layers thereof. The interior position of reservoirs 912 within package substrate 960 is not necessarily limited, though positioning generally near the lower surface 961 may be useful for purposes of forming the reservoirs 912 and/or filling the reservoirs 912 with solder. The planar shape of each reservoir 912 when viewed from a direction orthogonal to the lower surface 961 may be rectangular, square, polygonal, circular, annular, or irregular. Each reservoir 912 may be subdivided by internal structure(s), supports, or the like and/or provided as interconnected segments.

While as depicted in Fig. 10, each solder ball 910 is associated with a reservoir 912, this is not required. In some examples, reservoirs 912 may be provided for only some solder ball 910 locations. In some examples, adjacent reservoirs 912 may be interconnected to each other when electrical connection design permits such potential interconnection.

A solder mask 970 is shown covering the lower surface 961. Solder mask 970 may be the same composition, and provided for a generally similar purpose, as solder mask 270 in the examples described above. The solder mask 970 includes openings therein between each reservoir 912 and its associated solder ball 910. Solder is present in the openings in the solder mask 970. Also present in solder mask 970 are vent openings 923 which connect the interior of each reservoir 912 to an ambient pressure environment to permit outflow of solder from the reservoir 912 during reflow processing or the like. The presence of vent openings 923 may also aid filling of the reservoirs 912. The sizing and positioning of the vent opening 923 may be set to limit or prevent outflow of solder via the vent openings 923 during processing. Though shown with one vent opening 923 per reservoir 912, this is not a limitation and multiple vent openings 923 may be provided for each reservoir 912 or a vent opening 923 may be shared between reservoirs 912 (electrical design permitting). In general, the provision of a reservoir 912 connected to a vent opening 923 as depicted and described permits formation of self-extendable interconnector structures which can compensate for substrate warpage and irregularities when semiconductor device 900 is mounted onto a circuit board 300 or the like.

## Claims

1. A semiconductor device (100, 200), comprising:
a wiring substrate (260);
a chip (250) on a first surface of the wiring substrate (260); and
a plurality of protruding structures (220) on a second surface of the wiring substrate (260),
wherein
each protruding structure (220) includes a solder reservoir space therein,
wherein
a solder level in a solder reservoir space of a first protruding structure (220) in the plurality of protruding structures (220) is different from a solder level in a solder reservoir space of a second protruding structure (220) in the plurality of protruding structures (220).

2. The semiconductor device (100, 200) of claim 1, further comprising:
a solder ball (210) on a lower end of each protruding structure (220), wherein
the solder reservoir space contains solder.

3. The semiconductor device (100, 200) of claim 1 or 2, wherein
each protruding structure (220) comprises a tubular portion (225), and
at least a portion of the solder reservoir space is inside the tubular portion (225); wherein in particular
each protruding structure (220) further comprises a vent portion in the tubular portion (225), the vent portion connecting the solder reservoir space to an outside of the tubular portion (225).

4. The semiconductor device (100, 200) of any one of the claims 1 to 3, wherein
the plurality of protruding structures (220) are copper.

5. The semiconductor device (100, 200) of any one of the claims 1 to 4, wherein
the plurality of protruding structures (220) is in a regular array arrangement.

6. The semiconductor device (100, 200) of any one of the claims 1 to 5, wherein
each protruding structure (220) extends outwardly away from the wiring substrate (260) in a first direction.

7. The semiconductor device (100, 200) of claim 6, wherein
each protruding structure comprises:
a lower pad portion at an end of the protruding structure (220) farthest from the wiring substrate (260) in the first direction, and
an upper pad portion at an end of the protruding structure (220) closest to the wiring substrate (260); wherein in particular
each protruding structure (220) further comprises:
a tubular portion (225) extending in the first direction and connecting the lower pad portion to the upper pad portion, and
a vent portion (223) in the tubular portion (225),
at least a portion of the solder reservoir space is inside the tubular portion (225), and
the vent portion (223) connects the solder reservoir space to an outside of the tubular portion (225).

8. The semiconductor device (100, 200) of any one of the claims 1 to 7, wherein
each protruding structure (220) comprises a plurality of prong elements extending in a first direction from the wiring substrate (260), and
the solder reservoir space of each mounting post is between adjacent prong elements in a second direction perpendicular to the first direction; wherein in particular
each protruding structure (220) comprises three or four prong elements.

9. The semiconductor device (100, 200) of any one of the claims 1 to 8, wherein
each protruding structure (220) comprises a pair of plate elements (625) extending in a first direction from the wiring substrate (260), and
the solder reservoir space of each protruding structure (220) is the gap between the pair of plate elements (625) in a second direction perpendicular to the first direction.

10. The semiconductor device (100, 200) of claim 9, wherein
the plate elements (625) are flat plates;
and/or
the plate elements (625) are curved plates.

11. A semiconductor device (100, 200) of claim 1,
wherein each of the protruding structures (220) comprises a mounting post (220) on a second surface of the wiring substrate (260), each mounting post (220) extending from the second surface in a first direction substantially orthogonal to the second surface; and
a solder ball (210) on an end of each mounting post (220) farthest from the wiring substrate (260) in the first direction, wherein
each mounting post (220) has a solder reservoir space therein, and
at least one solder reservoir space has solder therein.

12. The semiconductor device of claim 11, wherein
each mounting posts (220) comprises a plurality of prong elements (825) extending in the first direction from the wiring substrate (260), and
the solder reservoir space of each mounting post is between adjacent prong elements in a second direction perpendicular to the first direction.

13. The semiconductor device of claim 11 or 12, wherein
each mounting post (220) comprises:
a lower pad portion (222) at the end of the mounting post (220) farthest from the wiring (260) substrate in the first direction,
an upper pad portion (221) at an end of the mounting post (220) closest to the wiring substrate (260),
a tubular portion (225) extending in the first direction and connecting the lower pad portion (222) to the upper pad portion (221), and
a vent portion (223) in the tubular portion (225),
at least a portion of the solder reservoir space is inside the tubular portion (225), and
the vent portion (223) connects the solder reservoir space to an outside of the tubular portion (225).

14. An electronic device, comprising:
a circuit board (300) with a plurality of mounting pads (220) at a surface thereof; and
a semiconductor device (100, 200) as set forth in any one of the preceding claims 1 to 10, the semiconductor device (100, 200) being soldered to the plurality of mounting pads (220).

## Patentansprüche

1. Eine Halbleitervorrichtung (100, 200), aufweisend:
ein Verdrahtungssubstrat (260);
einen Chip (250) auf einer ersten Oberfläche des Verdrahtungssubstrats (260); und
eine Mehrzahl von vorstehenden Strukturen (220) auf einer zweiten Oberfläche des Verdrahtungssubstrats (260), wobei
jede vorstehende Struktur (220) einen Lotreservoirraum darin enthält,
wobei
ein Lotpegel in einem Lotreservoirraum einer ersten vorstehenden Struktur (220) in der Mehrzahl von vorstehenden Strukturen (220) von einem Lotpegel in einem Lotreservoirraum einer zweiten vorstehenden Struktur (220) in der Mehrzahl von vorstehenden Strukturen (220) verschieden ist.

2. Die Halbleitervorrichtung (100, 200) gemäß Anspruch 1, ferner aufweisend:
eine Lotkugel (210) an einem unteren Ende jeder vorstehenden Struktur (220), wobei
der Lotreservoirraum Lot enthält.

3. Die Halbleitervorrichtung (100, 200) gemäß Anspruch 1 oder 2, wobei
jede vorstehende Struktur (220) einen röhrenförmigen Abschnitt (225) aufweist, und
zumindest ein Abschnitt des Lotreservoirraums innerhalb des röhrenförmigen Abschnitts (225) ist; wobei insbesondere
jede vorstehende Struktur (220) ferner einen Entlüftungsabschnitt in dem röhrenförmigen Abschnitt (225) aufweist, wobei der Entlüftungsabschnitt den Lotreservoirraum mit einer Außenseite des röhrenförmigen Abschnitts (225) verbindet.

4. Die Halbleitervorrichtung (100, 200) gemäß einem der Ansprüche 1 bis 3, wobei die Mehrzahl von vorstehenden Strukturen (220) Kupfer sind.

5. Die Halbleitervorrichtung (100, 200) gemäß einem der Ansprüche 1 bis 4, wobei die Mehrzahl von vorstehenden Strukturen (220) in einer regelmäßigen Array-Anordnung ist.

6. Die Halbleitervorrichtung (100, 200) gemäß einem der Ansprüche 1 bis 5, wobei
jede vorstehende Struktur (220) sich nach außen weg von dem Verdrahtungssubstrat (260) in einer ersten Richtung erstreckt.

7. Die Halbleitervorrichtung (100, 200) gemäß Anspruch 6, wobei
jede vorstehende Struktur aufweist:
einen unteren Pad-Abschnitt an einem Ende der vorstehenden Struktur (220), das am weitesten von dem Verdrahtungssubstrat (260) in der ersten Richtung entfernt ist, und
einen oberen Pad-Abschnitt an einem Ende der vorstehenden Struktur (220), das am nächsten zu dem Verdrahtungssubstrat (260) ist; wobei insbesondere
jede vorstehende Struktur (220) ferner aufweist:
einen röhrenförmigen Abschnitt (225), der sich in der ersten Richtung erstreckt und den unteren Pad-Abschnitt mit dem oberen Pad-Abschnitt verbindet, und
einen Entlüftungsabschnitt (223) in dem röhrenförmigen Abschnitt (225),
zumindest ein Abschnitt des Lotreservoirraums innerhalb des röhrenförmigen Abschnitts (225) ist,
und
der Entlüftungsabschnitt (223) den Lotreservoirraum mit einer Außenseite des röhrenförmigen Abschnitts (225) verbindet.

8. Die Halbleitervorrichtung (100, 200) gemäß einem der Ansprüche 1 bis 7, wobei
jede vorstehende Struktur (220) eine Mehrzahl von Zinkenelementen aufweist, die sich in einer ersten Richtung von dem Verdrahtungssubstrat (260) erstrecken, und
der Lotreservoirraum jedes Montagepfostens zwischen benachbarten Zinkenelementen in einer zweiten Richtung rechtwinklig zu der ersten Richtung ist; wobei insbesondere jede vorstehende Struktur (220) drei oder vier Zinkenelemente aufweist.

9. Die Halbleitervorrichtung (100, 200) gemäß einem der Ansprüche 1 bis 8, wobei
jede vorstehende Struktur (220) ein Paar von Plattenelementen (625) aufweist, die sich in einer ersten Richtung von dem Verdrahtungssubstrat (260) erstrecken, und
der Lotreservoirraum jeder vorstehenden Struktur (220) der Spalt zwischen dem Paar von Plattenelementen (625) in einer zweiten Richtung rechtwinklig zu der ersten Richtung ist.

10. Die Halbleitervorrichtung (100, 200) gemäß Anspruch 9, wobei
die Plattenelemente (625) flache Platten sind;
und/oder
die Plattenelemente (625) gekrümmte Platten sind.

11. Eine Halbleitervorrichtung (100, 200) gemäß Anspruch 1, wobei
jede der vorstehenden Strukturen (220) einen Montagepfosten (220) auf einer zweiten Oberfläche des Verdrahtungssubstrats (260) aufweist, wobei sich jeder Montagepfosten (220) von der zweiten Oberfläche in einer ersten Richtung im Wesentlichen orthogonal zu der zweiten Oberfläche erstreckt; und
eine Lotkugel (210) an einem Ende jedes Montagepfostens (220), das am weitesten von dem Verdrahtungssubstrat (260) in der ersten Richtung entfernt ist, wobei
jeder Montagepfosten (220) einen Lotreservoirraum darin hat, und
zumindest ein Lotreservoirraum Lot darin hat.

12. Die Halbleitervorrichtung gemäß Anspruch 11, wobei
jeder Montagepfosten (220) eine Mehrzahl von Zinkenelementen (825) aufweist, die sich in der ersten Richtung von dem Verdrahtungssubstrat (260) erstrecken, und
der Lotreservoirraum jedes Montagepfostens zwischen benachbarten Zinkenelementen in einer zweiten Richtung rechtwinklig zu der ersten Richtung ist.

13. Die Halbleitervorrichtung gemäß Anspruch 11 oder 12, wobei
jeder Montagepfosten (220) aufweist:
einen unteren Pad-Abschnitt (222) an dem Ende des Montagepfostens (220), das am weitesten von dem Verdrahtungssubstrat (260) in der ersten Richtung entfernt ist,
einen oberen Pad-Abschnitt (221) an einem Ende des Montagepfostens (220), das am nächsten zu dem Verdrahtungssubstrat (260) ist,
einen röhrenförmigen Abschnitt (225), der sich in der ersten Richtung erstreckt und den unteren Pad-Abschnitt (222) mit dem oberen Pad-Abschnitt (221) verbindet, und
einen Entlüftungsabschnitt (223) in dem röhrenförmigen Abschnitt (225),
zumindest ein Abschnitt des Lotreservoirraums innerhalb des röhrenförmigen Abschnitts (225) ist, und
der Entlüftungsabschnitt (223) den Lotreservoirraum mit einer Außenseite des röhrenförmigen Abschnitts (225) verbindet.

14. Eine elektronische Vorrichtung, aufweisend:
eine Leiterplatte (300) mit einer Mehrzahl von Montagepads (220) an einer Oberfläche davon; und
eine Halbleitervorrichtung (100, 200) gemäß einem der vorhergehenden Ansprüche 1 bis 10, wobei die Halbleitervorrichtung (100, 200) an die Mehrzahl von Montagepads (220) gelötet ist.

## Revendications

1. Dispositif à semi-conducteur (100, 200), comprenant :
un substrat de câblage (260) ;
une puce (250) sur une première surface du substrat de câblage (260) ; et
une pluralité de structures en saillie (220) sur une seconde surface du substrat de câblage (260), dans lequel
chaque structure en saillie (220) inclut un espace de réservoir de soudure en son sein, dans lequel
un niveau de soudure dans un espace de réservoir de soudure d'une première structure en saillie (220) de la pluralité de structures en saillie (220) est différent d'un niveau de soudure dans un espace de réservoir de soudure d'une seconde structure en saillie (220) de la pluralité de structures en saillie (220).

2. Dispositif à semi-conducteur (100, 200) selon la revendication 1, comprenant en outre :
une bille de soudure (210) sur une extrémité inférieure de chaque structure en saillie (220), dans lequel l'espace de réservoir de soudure contient de la soudure.

3. Dispositif à semi-conducteur (100, 200) selon la revendication 1 ou 2, dans lequel chaque structure en saillie (220) comprend une partie tubulaire (225), et
au moins une partie de l'espace de réservoir de soudure se trouve à l'intérieur de la partie tubulaire (225) ; dans lequel en particulier
chaque structure en saillie (220) comprend en outre une partie d'évent dans la partie tubulaire (225), la partie d'évent reliant l'espace de réservoir de soudure à l'extérieur de la partie tubulaire (225).

4. Dispositif à semi-conducteur (100, 200) selon l'une quelconque des revendications 1 à 3, dans lequel la pluralité de structures en saillie (220) sont en cuivre.

5. Dispositif à semi-conducteur (100, 200) selon l'une quelconque des revendications 1 à 4, dans lequel la pluralité de structures en saillie (220) est dans un agencement en réseau régulier.

6. Dispositif à semi-conducteur (100, 200) selon l'une quelconque des revendications 1 à 5, dans lequel chaque structure en saillie (220) s'étend vers l'extérieur en s'éloignant du substrat de câblage (260) dans une première direction.

7. Dispositif à semi-conducteur (100, 200) selon la revendication 6, dans lequel chaque structure en saillie comprend :
une partie de pastille inférieure à une extrémité de la structure en saillie (220) la plus éloignée du substrat de câblage (260) dans la première direction, et
une partie de pastille supérieure à une extrémité de la structure en saillie (220) la plus proche du substrat de câblage (260) ; dans lequel en particulier
chaque structure en saillie (220) comprend en outre :
une partie tubulaire (225) s'étendant dans la première direction et reliant la partie de pastille supérieure à la partie de pastille inférieure, et
une partie d'évent (223) dans la partie tubulaire (225),
au moins une partie de l'espace de réservoir de soudure est à l'intérieur de la partie tubulaire (225), et la partie d'évent (223) connecte l'espace de réservoir de soudure à l'extérieur de la partie tubulaire (225).

8. Dispositif à semi-conducteur (100, 200) selon l'une quelconque des revendications 1 à 7, dans lequel chaque structure en saillie (220) comprend une pluralité d'éléments de dent s'étendant dans une première direction à partir du substrat de câblage (260), et
l'espace de réservoir de soudure de chaque montants de montage est entre des éléments de dent adjacents dans une seconde direction perpendiculaire à la première direction ; dans lequel en particulier
chaque structure en saillie (220) comprend trois ou quatre éléments de dent.

9. Dispositif à semi-conducteur (100, 200) selon l'une quelconque des revendications 1 à 8, dans lequel chaque structure en saillie (220) comprend une paire d'éléments de plaque (625) s'étendant dans une première direction à partir du substrat de câblage (260), et
l'espace de réservoir de soudure de chaque structure en saillie (220) est l'espace entre la paire d'éléments de plaque (625) dans une seconde direction perpendiculaire à la première direction.

10. Dispositif à semi-conducteur (100, 200) selon la revendication 9, dans lequel les éléments de plaque (625) sont des plaques plates ; et/ou
les éléments de plaque (625) sont des plaques incurvées.

11. Dispositif à semi-conducteur (100) selon la revendication 1,
dans lequel chacune des structures en saillie (220) comprend un montant de montage (220) sur une seconde surface du substrat de câblage (260), chaque montant de montage (220) s'étendant à partir de la seconde surface dans une première direction sensiblement orthogonale à la seconde surface ; et
une bille de soudure (210) sur une extrémité de chaque montant de montage (220) la plus éloignée du substrat de câblage (260) dans la première direction, dans lequel
chaque montant de montage (220) présente un espace de réservoir de soudure en son sein, et au moins un espace de réservoir de soudure présente de la soudure en son sein.

12. Dispositif à semi-conducteur selon la revendication 11, dans lequel
chaque montant de montage (220) comprend une pluralité d'éléments de dent (825) s'étendant dans la première direction à partir du substrat de câblage (260), et
l'espace de réservoir de soudure de chaque montant de montage est entre des éléments de dent adjacents dans une seconde direction perpendiculaire à la première direction.

13. Dispositif à semi-conducteur selon la revendication 11 ou 12, dans lequel chaque montant de montage (220) comprend :
une partie de pastille inférieure (222) à l'extrémité du montant de montage (220) la plus éloignée du substrat de câblage (260) dans la première direction,
une partie de pastille supérieure (221) à une extrémité du montant de montage (220) la plus proche du substrat de câblage (260),
une partie tubulaire (225) s'étendant dans la première direction et reliant la partie de pastille inférieure (222) à la partie de pastille supérieure (221), et
une partie d'évent (223) dans la partie tubulaire (225),
au moins une partie de l'espace de réservoir de soudure est à l'intérieur de la partie tubulaire (225), et la partie d'évent (223) connecte l'espace de réservoir de soudure à l'extérieur de la partie tubulaire (225).

14. Dispositif électronique, comprenant :
une carte de circuit imprimé (300) avec une pluralité de pastilles de montage (220) à une surface de celle-ci ; et
un dispositif à semi-conducteur (100, 200) selon l'une quelconque des revendications précédentes 1 à 10, le dispositif à semi-conducteur (100, 200) étant soudé à la pluralité de pastilles de montage (220).
